# EUROPEAN PATENT APPLICATION

(11) **EP 2 728 687 A1**
(43) Date of publication of application: **07.05.2014**
(21) Application number: 13797579.3
(22) Date of filing: 29.01.2013
(51) Int. Cl.: H02G 1/14, H01B 12/02, H01B 13/00, H01L 39/04, H01R 4/68, H02G 15/34

(54) **STRUCTURE AND METHOD FOR CONNECTING FORMER OF SUPERCONDUCTING CABLE**

(30) Priority: 31.05.2012 JP 2012123861
(71) Applicant: Furukawa Electric Co., Ltd., Chiyoda-ku Tokyo 100-8322 (JP); International Superconductivity Technology Center, Kawasaki-shi, Kanagawa 213-0012 (JP)
(72) Inventor: TENG, Jun, Tokyo 100-8322 (JP); YAGI, Masashi, Tokyo 100-8322 (JP)
(74) Representative: Horn Kleimann Waitzhofer
(86) International application number: PCT/JP2013/051812
(87) International publication number: WO 2013/179686

(57) **Abstract**

A connection structure for connecting hollow formers (140) provided inside a superconducting cable (10), wherein the connection structure is characterized in that one end section and another end section of a hollow connecting conduit (145) are inserted into an open section (144) leading to a hollow interior section formed in a connection end section of each of the formers, the opposed connection end sections of the formers being welded together. The connection conduit (145) thereby ensures circulation of a refrigerant. Also, there is no incidence of the cooling medium circulation path being blocked when welding is performed in the connection conduit, allowing formers to be more easily connected.

## Description

### TECHNICAL FIELD

The present invention relates to a structure and a method for connecting formers located at centers of cable cores of superconducting cables.

### BACKGROUND ART

A superconducting cable includes a cable core which has a former and a superconducting wire and a thermal insulation tube which has a vacuum double tube structure to contain the cable core, and liquid cooling medium of ultralow temperature is circulated to cool the cable core inside the thermal insulation tube.

Then, in order to enhance the cooling efficiency of the superconducting wire and the former, the former is formed to be hollow and the liquid cooling medium is circulated also inside the hollow section.

In a case where the superconducting cable is used as a power supply line, the superconducting cable needs to be laid out from the power supply source to the distant power-consuming area; however, the superconducting cable has a limitation in length of single cable for manufacturing or logistic reasons. Thus, when performing long-distance cable laying, many superconducting cables need to be connected at the laying site.

Then, when connecting end sections of formers of the superconducting cables, a method of making the distal end sections butt against each other and connecting them by welding (for example, see Patent document 1), a method of inserting the respective formers through the both ends of a tubular conductor and swaging from outside to connect them (for example, see Patent document 2) and such like have been adopted.

In addition, as a method for connecting the joints of the hollow conductor, there is known a method of arranging a reinforcing pipe on the outer circumference of the hollow conductor and connecting the hollow conductor to the reinforcing pipe by brazing (Patent document 3).

### PRIOR ART DOCUMENTS

### PATENT DOCUMENTS

Patent Document 1: Japanese Patent Application Laid Open Publication No. 2009-136071
Patent Document 2: Japanese Patent Application Laid Open Publication No. 2006-302674
Patent Document 3: Japanese Patent Application Laid Open Publication No. H07-42882

### DISCLOSURE OF THE INVENTION

### PROBLEMS TO BE SOLVED BY THE INVENTION

However, when the distal end sections of the hollow formers butt against each other to be welded, the hollow sections are blocked or narrowed in some cases since a welding filler material used for the welding flows into the hollow sections, and thus the circulation of a cooling medium is disturbed and the cables cannot be cooled sufficiently in some cases. There is also a problem that if the welding is performed so as not to block the hollow internal sections of the formers, the welding cannot be performed up to near the hollow internal sections, and thus the welding strength becomes low or the process operation itself is troublesome to worsen the workability.

Also, when the formers are connected by swaging or brazing using the tubular conductor, there have been problems such that the contact condition therebetween is insufficient and the electric conductivity becomes worse, or an angular portion of the tubular conductor contacts the superconducting wires arranged outside the formers to cause a stress and electric field is concentrated at the angular portion of the tubular conductor to lower the insulation property.

An object of the present invention is to provide a structure and a method for connecting superconducting cables which maintains an internal hollow state of formers and enables good electrical transmission of superconductive conductor layers.

### MEANS FOR SOLVING THE PROBLEM

The present invention is a connection structure of formers for connecting hollow formers provided inside superconducting cables, wherein one end section and the other end section of a hollow connection conduit are inserted into open sections leading to hollow internal sections formed at connection end sections of the respective formers, and the opposed connection end sections of the respective formers are connected to each other by welding.

The connection structure according to the present invention may have a configuration in which a connection end section of each of the formers is formed of an end surface including an inclined surface which is inclined with respect to a longer direction of each of the formers, and corresponding inclined surfaces at the connection end sections of the respective formers are opposed to each other so as to form a wedge-shaped gap, and opposed end surfaces are connected to each other with a welding filler material.

The connection structure according to the present invention may have a configuration in which each of the end surfaces includes two inclined surfaces, one being large and the other being small, among two wedge-shaped gaps, one being a large wedge-shaped gap and the other being a small wedge-shaped gap, which are formed by the inclined surfaces between the opposed connection end sections of the respective formers, the large wedge-shaped gap is located at an upper side and the small wedge-shaped gap is located at a lower side, and each of the gaps is filled with the welding filler material.

The connection structure according to the present invention may have a configuration in which a maximum open width of the large wedge-shaped gap in the longer direction of the formers is three times or more as large as a maximum open width of the small wedge-shaped gap in the longer direction of the formers.

The connection structure according to the present invention may have a configuration in which each of the formers is formed by binding conductor wires, and at the connection end section, the conductor wires are integrally bonded.

The present invention is a connection method of formers for connecting hollow formers provided inside superconducting cables, including inserting one end section and the other end section of a hollow connection conduit into open sections leading to hollow internal sections formed at connection end sections of the respective formers; and connecting the opposed connection end sections of the respective formers to each other by welding.

The connection method according to present invention may have a configuration which includes forming, at a connection end section of each of the formers, an end surface which includes an inclined surface that is inclined with respect to a longer direction of each of the formers, and in which, in the connecting by the welding, corresponding inclined surfaces at the connection end sections of the respective formers are opposed to each other so as to form a wedge-shaped gap, and a welding filler material is filled between opposed end surfaces.

The connection method according to the present invention may have a configuration which includes providing the connection conduit with a detachable insertion auxiliary tool which is used while extending outside in a radial direction from an outer circumferential surface of the connection conduit and in which in the inserting of the one end section and the other end section of the connection conduit, an insertion operation of the connection conduit into the open sections of the respective formers is performed in a state where the insertion auxiliary tool is extending outside from between the opposed end surfaces of the respective connection end sections, and the insertion auxiliary tool is removed after the inserting.

The connection method according to the present invention may have a configuration in which in the forming of the end surface including the inclined surface, an end surface formed of two inclined surfaces, one being large and the other being small, is formed at the connection end section of each of the formers, and in the connecting by the welding, among two wedge-shaped gaps, one being a large wedge-shaped gap and the other being a small wedge-shaped gap, which are formed by the inclined surfaces between the opposed connection end sections of the respective formers, the large wedge-shaped gap is located at an upper side, the small wedge-shaped gap is located at a lower side, and each of the gaps is filled with the welding filler material.

The connection method according to the present invention may have a configuration including binding wires to form each of the formers and integrally bonding the wires at the connection end section.

### EFFECT OF THE INVENTION

The present invention enables good circulation of liquid cooling medium for cooling the internal sections since connection end sections of formers are connected to each other by welding in a state where a hollow connection conduit is inserted into open sections leading to hollow internal sections in connection end sections of the respective formers. Furthermore, existence of the connection conduit eliminates the concern that the hollow internal sections of the formers may be blocked, and thus, the bonding can be performed sufficiently to the entire surfaces of the connection ends and the bond strength can be improved.

In addition, by using the connection conduit at the bonding operation, blockage of the hollow internal sections of formers due to deformation of members forming the formers is prevented. Furthermore, since the existence of the connection conduit eliminates the concern about the blockage of the hollow internal sections of formers, the bonding operation can be performed easily and the workability can also be improved.

Then, different from a case where a tubular member is provided outside the formers, a convex portion is not generated around the outer circumferential surface of the formers, and thus, it is possible to eliminate a stress which is caused when superconducting wires are arranged around the outer circumference and improve durability and reliability. It is also possible to avoid the concentration of electric field in the superconducting wires and maintain a good insulation property even when a large electric current is applied.

In a case where end surfaces are connected to each other by a welding filler material in a state where inclined surfaces corresponding to the connection end sections of the opposed formers form a wedge-shaped gap, it is possible to easily spread the welding filler material throughout the opposed end surfaces of the formers facing each other to provide strong bonding and improve the workability.

In a case where two wedge-shaped gaps, one being large and the other being small, are formed between the connection end sections of the opposed formers with the large one provided at the upper side, when the large wedge-shaped gap is filled with the welding filler material, the wedge-shaped gap at the lower side is filled even when the welding filler material leaks downward, and it is possible to inhibit the welding filler material from being convex on the outer circumferential surface of the formers. Thus, the bonding operation can be easily performed and the workability can be improved.

Also, in a case where the large wedge-shaped gap has the maximum open width in the longer direction of the former which is three times or more as large as the maximum open width in the longer direction of the former of the small wedge-shaped gap, when the welding filler material moves from the large wedge-shaped gap to the small wedge-shaped gap located at the lower side, the small wedge-shaped gap can be sufficiently filled with the welding filler material.

In a case where the formers are formed by binding conductor wires, the formers themselves can have a high flexibility and the respective connection end sections can also easily butt against each other, and thus the workability can be improved.

In addition, since the wires are integrally bonded at each of the connection end sections, the conductor wires forming each of the formers do not separate at the bonding operation, the bonding operation is facilitated, the bonding strength can be enhanced, and furthermore, the connection resistance can also be lowered by the cross-section being integrated.

In a case where the connection conduit includes an insertion auxiliary tool which is extending from the outer circumferential surface to the outside in the radial direction thereof, the connection conduit can be inserted by using the insertion auxiliary tool, and thus the workability of the connection operation can be improved. Since the insertion auxiliary tool is detachable from the connection conduit and can be removed after the insertion operation, the operation thereafter is not disturbed and the workability is improved also in this respect.

### BRIEF DESCRIPTION OF DRAWINGS

FIG. 1 is a perspective view showing a structure of a superconducting cable.
FIG. 2A is a view showing a first connection operation process when connecting formers.
FIG. 2B is a view showing a connection operation process following FIG. 2A when connecting the formers.
FIG. 2C is a view showing a connection process following FIG. 2B when connecting the formers.
FIG. 2D is a view showing connection operation process following FIG. 2C when connecting the formers.
FIG. 3 is a view of a connection end section of one of the formers in FIG. 2B seen from the other former side.
FIG. 4A is a view showing an example of a case where inclined surfaces which have a same size are vertically formed at the connection end section of each of the formers.
FIG. 4B is a view showing an example of a case where same inclined surfaces which have an inclination angle larger than that of FIG. 4A are vertically formed at the connection end section of each of the formers.
FIG. 5 is a view showing an example of a case where an end surface formed of an inclined surface and a non-inclined surface is formed at the connection end section of each of the formers.
FIG. 6 is a view showing an example of a case where an end surface formed of only one inclined surface is formed at the connection end section of each of the formers.
FIG. 7 is a view showing an example where the connection conduit is inserted into an open section of each of the formers by using the insertion auxiliary tool.

### BEST MODE FOR CARRYING OUT THE INVENTION

### [Superconducting cable]

Hereinafter, an embodiment of the present invention will be described in detail on the basis of the drawings.

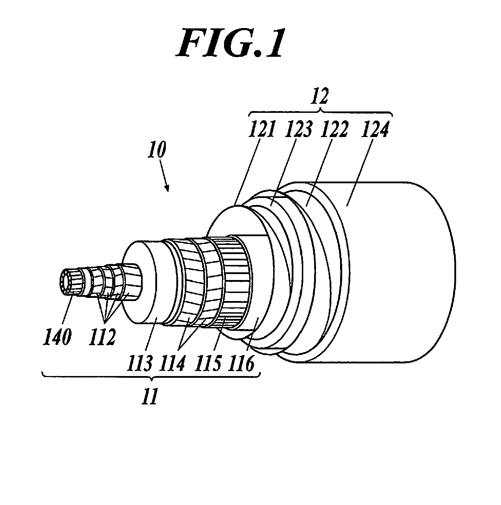

FIG. 1 is a view showing an example of the superconducting cable.

A superconducting cable 10 is a single-core superconducting cable in which a single cable core 11 is contained in a thermal insulation tube 12. The cable core 11 is configured by including a former 140, a superconductive conductor layer 112 which includes superconducting wires, an electric insulating layer 113, a superconducting shield layer 114, a normal conducting shield layer 115, a protecting layer 116 and such like.

The former 140 is a winding core for forming the cable core 11, and is formed by twisting a normal conducting wire (conductor line) such as a copper wire, for example. Fault current which flows through the superconductive conductor layer 112 upon short circuit is branched into the former 140.

The former 140 is formed to be hollow inside and liquid cooling medium (for example, liquid nitrogen) is supplied to the hollow section formed in the hollow part to cool the former 140 and the superconductive conductor layer 112. The liquid cooling medium is same as after-mentioned liquid cooling medium which is supplied to the circumference of the cable core 11 in the thermal insulation tube 12.

The superconductive conductor layer 112 is formed by spirally winding a plurality of superconducting wires via carbon paper (not shown in the drawings) on the former 140. In FIG. 1, the superconductive conductor layer 112 has a laminated structure of four layers. Transmission current is applied to the superconductive conductor layer 112 during a steady operation.

The superconducting wires forming the superconductive conductor layer 112 have a laminated structure in which an intermediate layer, a superconducting layer and a protecting layer are formed in order on a tape-shaped metal substrate, for example. As a superconductor forming the superconducting layer, a RE-based superconductor (RE: rare earth element) which becomes a superconducting state at a liquid nitrogen temperature or higher can be used. A typical RE-based superconductor is an yttrium-based superconductor (Y-based superconductor, hereinafter) which is expressed as the chemical formula YBa₂Cu₃O_{7-y}, for example. A tape-shaped superconducting wire in which a superconductor is formed in a metal matrix may be also used. As the superconductor, a bismuth-based superconductor which is expressed as the chemical formula Bi₂Sr₂CaCu₂O_{8+δ} (Bi2212) or Bi₂Sr₂Ca₂Cu₃O_{10+δ} (Bi2223), for example, can be applied.

The δ in the chemical formula indicates a nonstoichiometric amount of oxygen.

The electric insulating layer 113 is configured by including a type of insulating paper such as insulating paper, semi-synthesized paper obtained by bonding insulating paper with a polypropylene film, and a polymer non-woven tape, and the electric insulating layer 113 is formed by being wound so as to be laminated on the superconductive conductor layer 112.

The superconducting shield layer 114 is formed by spirally winding a plurality of superconducting wires via carbon paper (not shown in the drawings) on the electric insulating layer 113. In FIG. 1, the superconducting shield layer 114 has a laminated structure of two layers. Electric current which is nearly same as the conductor current is applied to the superconducting shield layer 114 in opposite phase by an electromagnetic induction during a steady operation. As the superconducting wire forming the superconducting shield layer 114, the same superconducting wire as that of the superconductive conductor layer 112 can be applied.

The normal conducting shield layer 115 is formed by winding a normal conducting wire such as a copper wire on the superconducting shield layer 114. Fault current which flows through the superconducting shield layer 114 upon short circuit is branched into the normal conducting shield layer 115.

A protecting layer 116 is configured by including a type of insulating paper such as insulating paper and a polymer non-woven tape, and formed by being wound on the normal conducting shield layer 115, for example.

The thermal insulation tube 12 has a double tube structure formed by a thermal insulation internal tube 121 which contains the cable core 11 and is filled with cooling medium (for example, liquid nitrogen) and a thermal insulation external tube 122 which is arranged so as to cover the outer circumference of the thermal insulation internal tube 121.

The thermal insulation internal tube 121 and the thermal insulation external tube 122 are a stainless-steel corrugated tube, for example. A multilayer thermal insulator (Super Insulation) 123 formed by a laminated body of polyethylene film which is vapor-deposited with aluminum, for example, intervenes between the thermal insulation internal tube 121 and the thermal insulation external tube 122 to be held in a vacuum state. Also, the outer circumference of the thermal insulation external tube 122 is covered with a corrosion-resistant layer 124 formed by polyvinyl chloride (PVC), polyethylene and such like.

### [Summary of structure for connecting formers of superconducting cables]

In a case where cables are laid out over a long distance, end sections of a plurality of superconducting cables 10 are connected to each other via known intermediate connecting parts. In the embodiment, a connection structure for connecting formers 140 and 140 when connecting two superconducting cables 10 and 10 is illustrated.

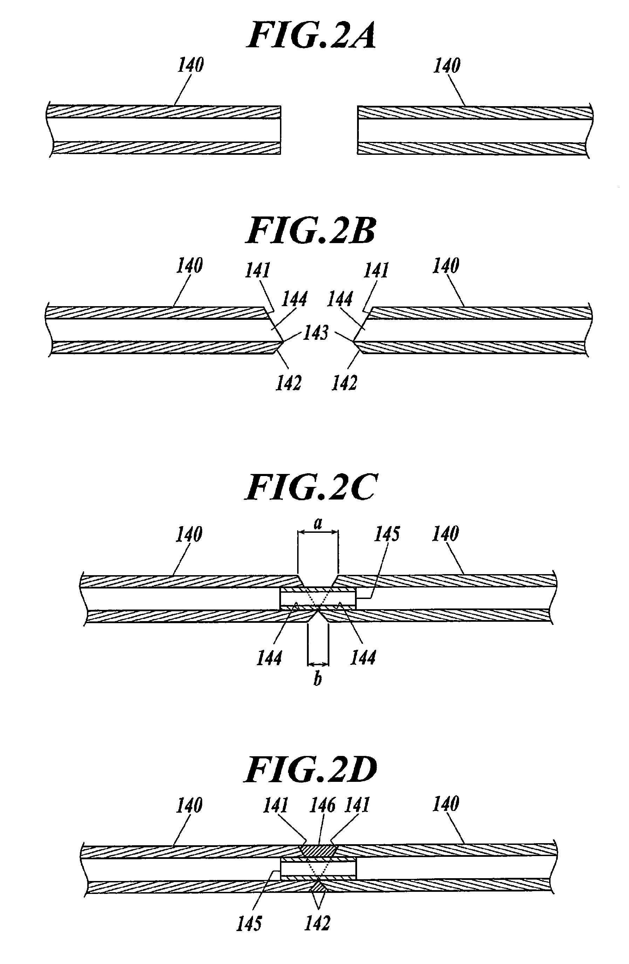

FIGS. 2A to 2D show connecting operation processes when connecting the formers 140 and 140. At an end section of each of the superconducting cables 10 and 10, an end section of the cable core 11 is pulled out from the thermal insulation tube 12, and the superconductive conductor layer 112, the electric insulating layer 113, the superconducting shield layer 114, the normal conducting shield layer 115 and the protecting layer 116 are stripped stepwise to expose a connection end section of the former 140.

As shown in FIG. 2A, at first, each of the formers 140 and 140 to be connected to each other has the end surface of the connection end section which is formed by a single flat surface perpendicular to the longer direction.

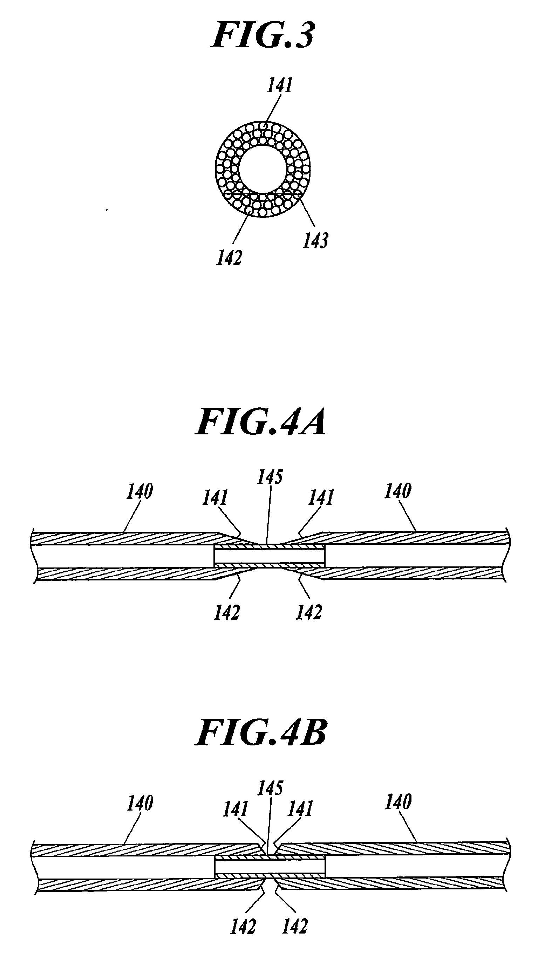

Then, as shown in FIG. 2B, two inclined surfaces are formed at the connection end section of each of the formers 140 (inclined surface forming process). The end surface of the connection end section of each of the formers 140 is formed of two inclined surfaces 141 and 142 as shown in FIG. 3, and each of the formers 140 is pointed-shaped in which a boundary section 143 that is the border of the two inclined surfaces 141 and 142 protrudes toward the other former 140. It is preferable that the entire size of the upper inclined surface 141 is formed to be larger than the lower inclined surface 142 in the vertical direction and the longer direction of the formers 140.

Since the formers 140 are formed by twisting a plurality of copper wires as mentioned above, at each of the upper and lower inclined surfaces 141 and 142, the gaps between the copper wires are fixed with a melted copper material so that the copper wires do not separate.

Then, as shown in FIG. 2C, an end section and the other end section of the connection conduit 145 are inserted into the respective open sections 144 leading to the hollow internal sections in the connection end sections of the formers 140, and the boundary sections 143 and 143 butt against each other to be in an opposed state (connection conduit inserting process). It is desirable that the boundary sections 143 and 143 are in parallel and contact with each other in terms of equal diameter connection; however, the boundary sections 143 and 143 may have a little gap therebetween.

The connection conduit 145 is designed to have an outer diameter which is nearly same as the inner diameter of the hollow formers 140 and can be inserted from the open sections 144. The connection conduit 145 is formed of a hollow conductor over the entire length, and it is preferable that the connection conduit 145 is formed of a same material as that of the former 140 in terms of connection compatibility upon welding. Specifically, it is preferable that a copper tubular body is used as the connection conduit 145 when the former 140 is made of copper, and a stainless-steel tubular body is used as the connection conduit 145 when the former 140 is made of stainless-steel. The connection conduit 145 inserted into the formers 140 has a structure which does not disturb the circulation of liquid cooling medium that flows from the hollow internal section of the one former 140 to the hollow internal section of the other former 140. Accordingly, a connection conduit 145 having a larger inner diameter is desirable; however, it is desirable that the inner diameter is determined while ensuring a predetermined strength since the strength is lowered if the wall of the connection conduit 145 becomes thinner.

Then, when the connection end sections of the formers 140 and 140 butt against each other so as to fit the boundary sections 143 and 143 to each other with the inclined surfaces 141 and 141 facing upward, between the connection end sections, a wedge-shaped gap space is formed between the upper inclined surfaces 141 and 141 and between the lower inclined surfaces 142 and 142 each. At this time, a desirable maximum open width a (width in the longer direction of former 140) of the upper wedge-shaped gap space is approximately three to four times as large as the maximum open width b of the lower wedge-shaped gap space. Here, the maximum open width a is three times as large as the maximum open width b.

Next, as shown in FIG. 2D, the connection end sections of the respective formers 140 are welded by using a welding filler material 146 from above (welding process). At this time, when the upper wedge-shaped gap space is filled with the welding filler material 146 (solder, copper and such like), the welding filler material also enters the lower wedge-shaped gap space from between the boundary sections 143 and 143, and as a result, both of the upper wedge-shaped gap space and the lower wedge-shaped gap space are filled with the welding filler material 146.

Thus, the whole range of the exposed outer circumferential surface of the connection conduit 145, the upper inclined surfaces 141 and 141 and the lower inclined surfaces 142 and 142 is attached firmly to the welding filler material 146, and the connection end sections of the formers 140 and 140 can be firmly connected to each other. In addition, the connection conduit 145 inhibits the hollow internal sections of the formers 140 from being blocked with the welding filler material 146, and a good communicated state between the hollow internal sections is maintained.

In a case where the welding filler material 146 protrudes outside the upper and lower wedge-shaped gap space, it is preferable that the bonded part by the welding filler material 146 is polished so as to be equal to the outer diameter of the formers 140 and 140 to remove the excess welding filler material.

After connecting the formers 140 and 140 of the respective cable cores 11 and 11 to each other, superconducting wires are arranged via carbon paper on the outer circumferential surfaces and the superconducting wires own by the respective cable cores 11 and 11 are connected to each other by soldering to form the superconductive conductor layer 112.

Then, the insulation paper is wound on the superconductive conductor layer 112 to form the electric insulating layer 113. At this time, since the insulation property needs to be more enhanced for the connection end of the superconducting wires which are connected by soldering, the insulation paper is wound until the outer diameter thereof becomes larger than the original electric insulating layer 113 of the cable core 11.

Then, superconducting wires to be connected to each other by soldering are arranged on the electric insulating layer 113, the superconducting shield layer 114 is formed, and further on top of them, the normal conducting shield layer 115 and the protecting layer 116 are formed.

Thus, the end sections of the cable cores 11 and 11 of the superconducting cables 10 and 10 are connected to each other. Furthermore, the connection part of the cables cores 11 and 11 of the superconducting cables 10 and 10 is stored in a thermal insulation container. Each of the thermal insulation tubes 12 and 12 of the superconducting cables 10 and 10 is connected to the thermal insulation container which contains the connection part.

As a result, liquid cooling medium supplied into the thermal insulation tubes 12 and 12 can circulate via the thermal insulation container, and a cooling means at the connection part of the cable cores 11 and 11 is also secured.

In such way, when connecting the cable cores 11 and 11 of the superconducting cables 10 and 10, since the connection end sections of the formers 140 and 140 are connected to each other by welding using a welding filler material in a state where the hollow connection conduit 145 is inserted into the open sections 144 and 144 leading to the hollow internal sections of the connection end sections of the respective formers 140 and 140, the blockage of the hollow internal sections of the formers 140 and 140 during the connection operation is prevented, enabling the good circulation of the liquid cooling medium for cooling the inside.

Also, since there is no concern that the welding filler material blocks the hollow internal sections of the formers 140 and 140, the whole of the connection end surfaces can be sufficiently bonded, and the bond strength can be improved. In addition, since there is no concern that the welding filler material blocks the hollow internal sections of the formers 140 and 140, the bonding operation can be easily performed and the workability can also be improved.

Furthermore, different from a case where the formers 140 and 140 are connected to each other by providing a tubular member outside them, since the convex portion is not generated on the outer circumferential surface of each of the formers 140 and 140, the stress of the superconductive conductor layer 112 to the superconducting wires due to the convex portion on the surface of the former 140 is resolved, and durability and reliability of the superconducting wires can be improved. Also, even in a case where a large current is applied, it is possible to avoid the concentration of the electric field at the angular portion of the tubular conductor and maintain a good insulation property.

Furthermore, between the opposed connection end sections of the formers 140 and 140, when the larger wedge-shaped gap formed of the inclined surfaces 141 and 141 is located at the upper side and filled with the welding filler material, the smaller wedge-shaped gap made by the inclined surfaces 142 and 142 is also filled with the welding filler material, and it is possible to spread the welding filler material throughout the connection end sections, bond them firmly and improve the bonding workability.

At that time, in a case where the maximum open width a of the large wedge-shaped gap in the longer direction of the former 140 is three times the maximum open width b of the small wedge-shaped gap, the welding filler material moves from the large wedge-shaped gap to the small wedge-shaped gap at the lower side, and the small wedge-shaped gap can also be filled with the welding filler material without deficiency and excess.

In a case where each of the formers 140 and 140 is formed by binding conductor (copper) wires, the formers 140 and 140 themselves can have a high flexibility, the connection end sections thereof also easily butt against each other, and thus the workability can be improved.

In addition, by integrally bonding the wires at each of the connection end sections, the conductor wires forming the former 140 do not separate during the bonding operation, and thus, the bonding operation is facilitated and the bond strength can be enhanced. When integrally bonding wires at each of the connection end sections, a preferable material used for the fixing is the same material as the material of the conductor wires in terms of suppressing unevenness of electrical performance at the connection part after welding.

### [Other examples of structure for connecting formers]

In the above connection structure of the formers 140 and 140, an end surface formed of the two inclined surfaces 141 and 142 is formed at each of the connection end sections, and two wedge-shaped gaps which are large and small are formed by the end surfaces; however, the wedge-shaped gaps may have a uniform size as shown in FIGS.4A and 4B. FIG. 4A shows a case where the two inclined surfaces 141 and 142 have a same inclination angle with respect to the longer direction of the former 140 and the inclination angle is small, and FIG. 4B shows a case where the two inclined surfaces 141 and 142 have a same inclination angle with respect to the longer direction of the former 140 and the inclination angle is a little larger than that of FIG. 4A.

Also in the cases, the connection conduit 145 prevents the hollow internal section of each of the formers 140 and 140 from being blocked, and thus connection can be made maintaining firm and good insulation property, and in addition, the workability can be improved.

Furthermore, upon welding, the welding filler material can fill the lower wedge-shaped gap from the upper wedge-shaped gap, and the workability of the bonding can also be improved.

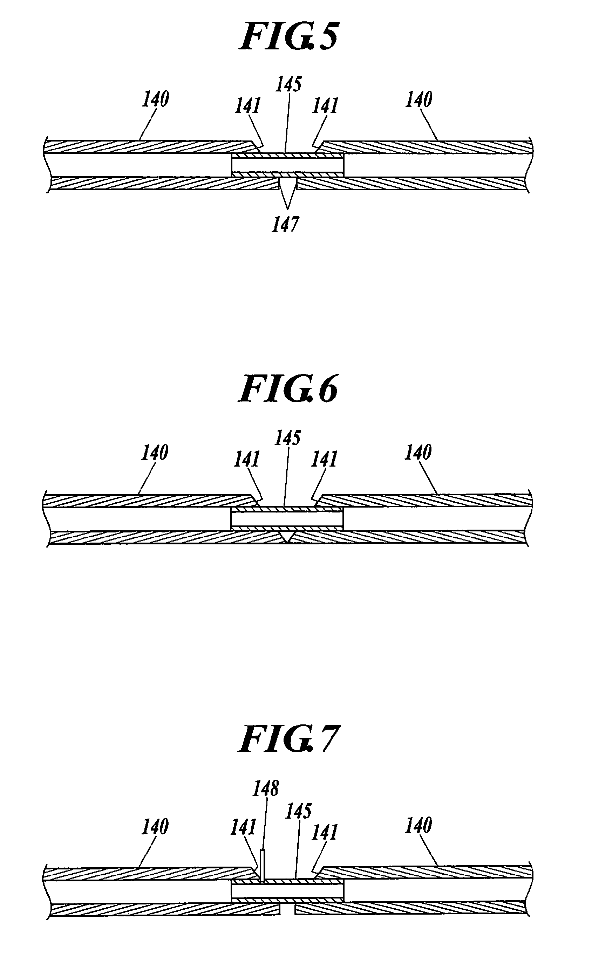

Also, as shown in FIG. 5, bonding may be performed by forming an end surface which is formed of the inclined surface 141 and a vertical surface 147 vertical to the longer direction of the former at the connection end section of each of the formers 140 and 140, forming a wedge-shaped gap by the inclined surfaces 141 and 141 and a parallel gap by the vertical surfaces 147 and 147 as an arrangement for matching the inclined surfaces 141 and 141 to each other, and filling the wedge-shaped gap which is directed upward.

Also in this case, the connection conduit 145 prevents the blockage of the hollow internal section of each of the formers 140 and 140, and thus connection can be made maintaining firm and good insulation property, and in addition, the workability can be improved.

Furthermore, by directing the wedge-shaped gap upward, the welding filler material filling the wedge-shaped gap also flows into the parallel gap to fill the gap, and the workability of the bonding can be improved. Also, different from the cases of FIGS. 4A and 4B, since the volume of the parallel gap is smaller than that of the wedge-shaped gap, the parallel gap can be filled with the welding filler material without deficiency and excess. Accordingly, it is possible to inhibit the protrusion of the welding filler material outside due to excess filling with the welding filler material to the lower gap and eliminate the need of removal operation and such like of excess welding filler material while enhancing the bond strength.

Since only a single inclined surface 141 is formed at the former 140, the man-hour of the connecting operation can be reduced.

As shown in FIG. 6, bonding may be performed by forming only an end surface formed of a single inclined surface 141 at the connection end section of each of the formers 140 and 140 and filling the wedge-shaped gap made by the inclined surfaces 141 and 141 which is directed upward with the welding filler material.

Also in this case, the connection conduit 145 inhibits the blockage of the hollow internal section of each of the formers 140 and 140, connection can be made maintaining firm and good insulation property, and workability can also be improved.

Also in this case, since the only one inclined surface 141 is formed, the man-hour of the connection operation can be reduced; however, since only the wedge-shaped gap is formed between the connection end sections of the formers 140 and 140, the bonding operation needs to be performed while adjusting the filling amount of the welding filler material so that the filled welding filler material does not leak downward.

Though not shown in the drawings, the connection end section of each of the formers 140 and 140 may have only an end surface vertical to the longer direction of the former to connect the connection end sections of the formers 140 and 140 to each other by the connection conduit 145. In such case, an end section of the connection conduit 145 is inserted to the open section 144 of the one former 140, fixing is performed by welding therebetween, and thereafter, the other end section of the connection conduit 145 is inserted into the open section 144 of the other former 140, and the opposed end surfaces of the formers 140 and 140 are connected by welding.

In this case, since a wedge-shaped gap space made by an inclined surface is not formed, filling of the space with the welding filler material is not necessary, and thus it is also possible to perform welding by melting a part of the members of the formers 140 and 140 and the connection conduit 145 without using the welding filler material. It is also possible to perform welding by using a small amount of welding filler material.

As shown in FIG. 7, a detachable insertion auxiliary tool 148 which fits to a concave portion formed at the outer circumferential surface section of the connection conduit 145 may be used to perform insertion operation of the connection conduit 145 into the open sections 144 and 144 (see FIG. 2B) of the formers 140 and 140. The insertion auxiliary tool 148 is attached while extending from the outer circumferential surface of the connection conduit 145 to the outside in the radial direction thereof, and when inserting the connection conduit 145 into the open sections 144 and 144 of the respective formers 140 and 140, the insertion auxiliary tool 148 protrudes outside from a gap (for example, a wedge-shaped gap) between the end surfaces at the connection end sections of the respective formers 140 and 140, and by operating the insertion auxiliary tool 148, the connection conduit 145 can be adjusted to an appropriate position in the longer direction of the former 140.

Since the insertion auxiliary tool 148 is detachable from the connection conduit 145, the insertion auxiliary tool 148 can be detached to be removed when the insertion process of the connection conduit 145 is completed. Accordingly, at the welding operation, the operation can be performed in a state where the insertion auxiliary tool 148 is removed. Since the insertion auxiliary tool 148 is not left attached to the former 140, it does not disturb the formation of the superconductive conductor layer 112 on the outer circumference of the former 140.

In FIG. 7, the formers 140 having the same shape of the connection end sections as that of FIG. 5 is illustrated; however, the formers 140 are not limited to this, and the example shown in FIG. 7 can be utilized for connection operation of any of the formers 140 in FIGS. 2C, 4A, 4B and 6.

### INDUSTRIAL APPLICABILITY

The present invention has an applicability at a field of superconducting cable in which a former is hollow and cooling is performed therein at cryogenic temperatures.

### EXPLANATION OF REFERENCE NUMERALS

- 10: superconducting cable
- 11: cable core
- 12: thermal insulation tube
- 112: superconductive conductor layer
- 113: electric insulating layer
- 114: superconducting shield layer
- 115: normal conducting shield layer
- 116: protecting layer
- 140: former
- 141, 142: inclined surface
- 144: open section
- 145: connection conduit
- 146: welding filler material
- 147: vertical surface
- 148: insertion auxiliary tool

## Claims

1. A connection structure of formers for connecting hollow formers provided inside superconducting cables, comprising:
a connection conduit which is hollow,
wherein
one end section and the other end section of the connection conduit are inserted into open sections leading to hollow internal sections formed at connection end sections of the respective formers, and
the opposed connection end sections of the respective formers are connected to each other by welding.

2. The connection structure of the formers according to claim 1,
wherein
a connection end section of each of the formers is formed of an end surface including an inclined surface which is inclined with respect to a longer direction of each of the formers, and
corresponding inclined surfaces at the connection end sections of the respective formers are opposed to each other so as to form a wedge-shaped gap, and opposed end surfaces are connected to each other with a welding filler material.

3. The connection structure of the formers according to claim 2, wherein
each of the end surfaces includes two inclined surfaces, one being large and the other being small,
among two wedge-shaped gaps, one being a large wedge-shaped gap and the other being a small wedge-shaped gap, which are formed by the inclined surfaces between the opposed connection end sections of the respective formers, the large wedge-shaped gap is located at an upper side and the small wedge-shaped gap is located at a lower side, and each of the gaps is filled with the welding filler material.

4. The connection structure of the formers according to claim 3, wherein
a maximum open width of the large wedge-shaped gap in the longer direction of the formers is three times or more as large as a maximum open width of the small wedge-shaped gap in the longer direction of the formers.

5. The connection structure of the formers according to any one of claims 1 to 4, wherein
each of the formers is formed by binding conductor wires, and at the connection end section, the conductor wires are integrally bonded.

6. A connection method of formers for connecting hollow formers provided inside superconducting cables, comprising:
inserting one end section and the other end section of a hollow connection conduit into open sections leading to hollow internal sections formed at connection end sections of the respective formers; and
connecting the opposed connection end sections of the respective formers to each other by welding.

7. The connection method of the formers according to claim 6, further comprising:
forming, at a connection end section of each of the formers, an end surface which includes an inclined surface that is inclined with respect to a longer direction of each of the formers,
wherein,
in the connecting by the welding, corresponding inclined surfaces at the connection end sections of the respective formers are opposed to each other so as to form a wedge-shaped gap, and a welding filler material is filled between opposed end surfaces.

8. The connection method of the formers according to claim 7, further comprising:
providing the connection conduit with a detachable insertion auxiliary tool which is used while extending outside in a radial direction from an outer circumferential surface of the connection conduit,
wherein
in the inserting of the one end section and the other end section of the connection conduit, an insertion operation of the connection conduit into the open sections of the respective formers is performed in a state where the insertion auxiliary tool is extending outside from between the opposed end surfaces of the respective connection end sections, and the insertion auxiliary tool is removed after the inserting.

9. The connection method of the formers according to claim 7 or 8, wherein
in the forming of the end surface including the inclined surface, an end surface formed of two inclined surfaces, one being large and the other being small, is formed at the connection end section of each of the formers, and
in the connecting by the welding, among two wedge-shaped gaps, one being a large wedge-shaped gap and the other being a small wedge-shaped gap, which are formed by the inclined surfaces between the opposed connection end sections of the respective formers, the large wedge-shaped gap is located at an upper side, the small wedge-shaped gap is located at a lower side, and each of the gaps is filled with the welding filler material.

10. The connection method of the formers according to any one of claims 6 to 9, further comprising:
binding wires to form each of the formers and integrally bonding the wires at the connection end section.
